# EUROPÄISCHE PATENTANMELDUNG

(11) **EP 3 716 746 A1**
(43) Veröffentlichungstag der Anmeldung: **30.09.2020**
(21) Anmeldenummer: 19166146.1
(22) Anmeldetag: 29.03.2019
(51) Int. Cl.: H05K 9/00

(54) **ELEKTROMAGNETISCHE SCHIRMUNGSVORRICHTUNG**

(71) Anmelder: Siemens Aktiengesellschaft, 80333 München (DE)
(72) Erfinder: Rieger, Gotthard, 80636 München (DE); Schuh, Carsten, 85598 Baldham (DE)

(57) **Zusammenfassung**

Die Erfindung gibt ein Verfahren zur Herstellung einer eine elektromagnetische Schirmwirkung aufweisende Schirmungsvorrichtung (2), dadurch gekennzeichnet, dass auf ein Substrat (1) durch Aerosolabscheidung eine Schicht (3) aus einem weichmagnetischen Material aufgebracht wird.

Außerdem gibt die Erfindung eine Schirmungsvorrichtung (2) an.

## Beschreibung

### HINTERGRUND DER ERFINDUNG

### Gebiet der Erfindung

Die vorliegende Erfindung betrifft ein Verfahren zur Herstellung einer eine elektromagnetische Schirmwirkung aufweisende Schirmungsvorrichtung. Die Erfindung betrifft des Weiteren eine Schirmungsvorrichtung. Die Erfindung kann insbesondere zur breitbandigen Schirmung im nieder- und hochfrequenten Wechselstrombereich verwendet werden.

### Beschreibung des Stands der Technik

Abschirmungen werden oft im Bereich hochfrequenter elektromagnetischer Wechselfelder, d.h. bei einigen kHz bis zum GHz-Bereich eingesetzt. Als Abschirmungen finden sich hier z.B. dünne metallische Beschichtungen, Folien oder Geflechte. Bei der Materialauswahl ist hier die elektrische Leitfähigkeit entscheidend, so dass häufig Kupfer oder Aluminium zum Einsatz kommen.

Bei magnetischen Abschirmungen wird dagegen die Schirmwirkung hauptsächlich durch die hohe Permeabilität einer weichmagnetischen Legierung (z.B. NiFe) mit geeigneter Mikrostruktur erreicht. Diese Schirmungen werden in einem Frequenzbereich von DC bis zu einigen 100 Hz eingesetzt. Dies deckt den Bereich ab, in dem die meisten magnetischen Störungen auftreten - vor allem durch 50/60 Hz- bzw. 16 2/3 Hz-Wechselfelder mit Feldstärken bis ca. 10 µT. Auch magnetische Gleichfelder sind zunehmend in Anwendungen präsent. Dies gilt im gesamten Bereich der DC Stromversorgung sowie bei Geräten mit magnetischen Gleichfeldern, wie z.B. Kernspintomographen.

Als Abschirmmaterial mit höchstem Schirmfaktor bei Niederfrequenz wird typischerweise Mu-Metall als freitragende Folie bzw. Blech eingesetzt. Nachteilig sind dabei die Handhabung bzw. die Integration in Gehäuse, z.B. als Schirmstruktur in elektronischen Komponenten wie Schalter/Schütze. Auch die Kombination mit weiteren Schichten oder als Mehrfachschicht gestaltet sich schwierig. Zur Integration in Elektronik wird daher mitunter ein mit Weichmagnetpartikeln hoch gefülltes Polymer vorgeschlagen, das aber durch die geringe Permeabilität ("innere Luftspalte") eine vergleichsweise geringe Schirmwirkung aufweist und daher als ungeeignet eingeschätzt wird (siehe "Kunststoffe und EMV", Ulrich Leute, expert Verlag). In einem weiteren Schichtaufbau wird die Mu-Metall Folie mit einer leitfähigen Silberschicht (hochgefülltes Silber in Polymer) versehen, welches die Komplexität des Aufbaus und der Integration weiter erhöht (Mu-ferro tape with conductive adhesive (3208) von Holland Shielding B.V.).

Als Stand der Technik können:
- Dünne Magnetbleche aus ferromagnetischen Materialien mit hoher Permeabilität zum Aufbau als Blech, Deckel, Dose, Gehäuse etc. überwiegend in Form von Stanzteilen,
- Amorphe Bänder auf Fe- oder Co-Basis aus der Rascherstarrung in Anwendung durch Umwickeln z.B. von Kabeln und
- Weichmagnetische Komposit-Folie mit Ferrit oder ferromagnetischen Metallpartikeln oft mit metallisch leitfähiger Beschichtung (aber nur geringe Schirmwirkung bei DC-Magnetfeldern)
   angesehen werden.

### ZUSAMMENFASSUNG DER ERFINDUNG

Die Aufgabe der Erfindung besteht darin, eine Lösung für ein verbessertes Verfahren zur Herstellung einer Schirmvorrichtung bereitzustellen.

Die Erfindung ergibt sich aus den Merkmalen der unabhängigen Ansprüche. Vorteilhafte Weiterbildungen und Ausgestaltungen sind Gegenstand der abhängigen Ansprüche. Weitere Merkmale, Anwendungsmöglichkeiten und Vorteile der Erfindung ergeben sich aus der nachfolgenden Beschreibung.

Ein Aspekt der Erfindung ist ein Verfahren zur Herstellung einer geschichteten Schirmvorrichtung im niederfrequenten Gleichstrombereich, wobei die Schirmvorrichtung direkt in Bauelemente oder Gehäuse integriert werden kann sowie mit weiteren elektrisch leitfähigen Schichten zur Erhöhung des Frequenzbereichs kombiniert werden kann.

Die Erfindung beansprucht ein Verfahren zur Herstellung einer eine elektromagnetische Schirmwirkung aufweisende Schirmungsvorrichtung, dadurch gekennzeichnet, dass auf ein Substrat durch Aerosolabscheidung (auch als Aerosol-Deposition Method ADM bekannt) eine geschlossene nanokristalline Schicht aus einem weichmagnetischen Material aufgebracht wird. Dies bietet den Vorteil, dass die Schirmwirkung sowohl im niederfrequenten Bereich (hohe magn. Permeabilität) als auch im hochfrequenten Wechselstrombereich bei einer Frequenz größer 100 kHz (hohe elektrische Leitfähigkeit) liegt.

Das Verfahren hat den Vorteil, dass die so hergestellte Schirmvorrichtung direkt in Bauelemente oder Gehäuse integriert werden kann sowie mit weiteren elektrisch leitfähigen Schichten zur Erhöhung des Frequenzbereichs kombiniert werden kann.

In einer weiteren Ausgestaltung kann die Schicht eine beliebige vorgegebene Struktur bilden.

In einer weiteren Ausgestaltung kann das Substrat ein Gehäuse eines elektronischen Bauteils oder eine Leiterplatte sein.

In einer weiteren Ausgestaltung kann das Substrat eine schirmende Kupfer- oder Aluminiumschicht sein.

In einer weiteren Ausgestaltung kann das weichmagnetische Material eine metallische Legierung sein.

In einer weiteren Ausgestaltung kann die metallische Legierung aus einem kristallinen, amorphen oder nanokristallinen Material mit geringem Koerzitivfeld (d.h. im Bereich von -0,5 bis 5 A/m liegen) und geringer Sättigungsmagnetostriktion (d.h. im Bereich von 0,01 bis 10 ppm liegen) gebildet sein. Mögliche Materialen sind z.B. NiFe, CoFeSiBNbCu.

In einer weiteren Ausgestaltung kann auf die Schicht zumindest eine weitere Schicht mit aufgebracht sein, wobei die weitere Schicht funktionale Eigenschaften ausweist.

In einer weiteren Ausgestaltung können die weiteren Schichten elektrisch isolierende und/oder wärmeableitende Eigenschaften aufweisen.

Die Erfindung beansprucht außerdem eine Schirmungsvorrichtung mit einer elektromagnetischen Schirmwirkung aufweisend eine durch Aerosolabscheidung auf ein Substrat aufgebrachte Schicht aus einem weichmagnetischen Material.

Die Erfindung kann dafür verwendet werden auf eine Substratoberfläche mittels Aerosolabscheidung/ Aerosol Deposition Method (ADM) eine Schicht oder andere Abschirmstruktur aus weichmagnetischem Material aufzubringen. Ziel ist die Abscheidung einer hochpermeablen magnetischen Schicht als allgemeine Schirmschicht z. B. in der Form einer Innenbeschichtung z. B. eines Gehäuses. Als besonders geeignete metallische Legierungen hierfür kommen bekannte kristalline oder amorphe bzw. nanokristalline Materialien mit geringem Koerzitivfeld und geringer Magnetostriktion infrage (z.B. NiFe, CoFeSiBNbCu).

Der Einsatz der Aerosolabscheidung ist dabei besonders vorteilhaft, weil damit bei Raumtemperatur bereits dichte, aber stark nanokristalline Gefüge erzeugt werden können. Eine nachfolgende Wärmebehandlung, z.B. Sinterung, die z.B. ein Kunststoffgehäuse, eine vorgefertigte Leiterplatte oder einen (leistungs-) elektronischen Aufbau schädigen könnte, kann damit entfallen.

Der Erhalt eines nanokristallinen Gefüges ist dabei insbesondere für weichmagnetische Materialien sehr günstig, da die kristalline Anisotropie unterhalb der Blochwanddicke ausgemittelt wird und sich daher keine Verankerung von Blochwänden (Pinning) einstellt, die zu reduzierter Permeabilität und geringerem Schirmfaktor führt (statistische Potentialtheorie). Gleichzeitig wird in nanokristallinen Eisen-Basislegierungen die Magnetostriktion nahezu null.

Vorteilhafterweise wird als Substratoberfläche direkt das Gehäuse, z.B. eines Elektronikbauteils oder die (flexible) Leiterplatte beschichtet. Auch die Beschichtung einer hochfrequent schirmenden Kupfer- oder Aluminiumschicht ist möglich.

Die vorliegende erfindungsgemäße Lösung zeichnet sich durch folgende Vorteile aus:
- nanokristalline Gefügestruktur der weichmagnetischen Schichten führt zu verbesserten Schirmungseigenschaften (hoher Schirmfaktor, virtuell verschwindende Magnetostriktion; wichtig insbesondere für die im grob-kristallinen nichtmagnetostriktionsfreien Eisenbasislegierungen (kostengünstiger als NiFe)
- einfache Realisierung einer nanokristallinen Schicht auf einem Substrat mit dem Niedertemperatur-Abscheideverfahren ADM
- erhöhte Freiheitsgrade zur Designoptimierung der Abschirmung
- gute mechanische Anbindung der Abschirmung durch Direktauftrag
- einfache Kombination mit weiteren funktionalen Schichten, z.B. elektrisch leitfähigen Schichten zur hochfrequenten Abschirmung, Schichten zur elektrischen Isolation oder Wärmeableitung
- kosteneffiziente Herstellung durch das Hochrate-Abscheidungsverfahren ADM inkl. Möglichkeit zur hochgradigen Automatisierung und Parallelisierung der Schichterzeugung

### KURZE BESCHREIBUNG DER ZEICHNUNGEN

Die Besonderheiten und Vorteile der Erfindung werden aus den nachfolgenden Erläuterungen mehrerer Ausführungsbeispiele anhand von schematischen Zeichnungen ersichtlich.

Es zeigen
- Fig. 1: eine Schirmungsvorrichtung,
- Fig. 2: Herstellprozess einer Schirmungsvorrichtung und
- Fig. 3: Schirmungsvorrichtung auf einer Leiterplatte.

### DETAILLIERTE BESCHREIBUNG DER ERFINDUNG

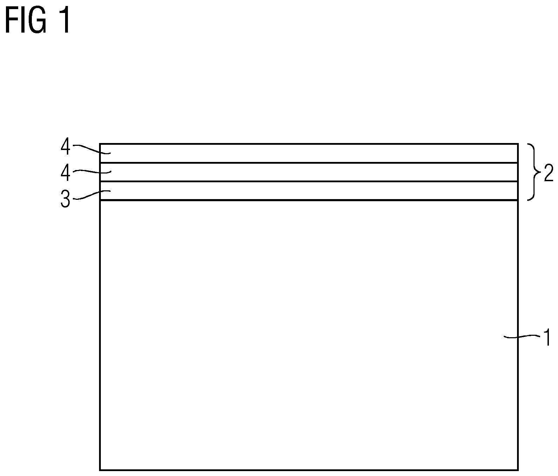

Fig. 1 zeigt eine schematische Darstellung einer Schirmungsvorrichtung 2. Die Schirmungsvorrichtung 2 weist eine durch Aerosolabscheidung auf ein Substrat 1 aufgebrachte weichmagnetische Schicht 3 aus einem weichmagnetischen Material mit einer elektromagnetischen Schirmwirkung auf.

Auf der weichmagnetischen Schicht 3 sind in Fig. 1 zwei weitere Schichten 4 aufgebracht, wobei die weiteren Schichten 4 funktionale Eigenschaften (z. B. elektrisch isolierende und/oder wärmeableitende Eigenschaften) ausweisen.

Das Substrat 1 kann z. B. ein Gehäuse eines elektronischen Bauteils oder eine Leiterplatte und/ oder eine schirmende Kupfer- oder Aluminiumschicht sein.

Das weichmagnetische Material kann eine metallische Legierung aus einem kristallinen, amorphen oder nanokristallinen Material mit geringem Koerzitivfeld und geringer Magnetostriktion sein.

Alternativ zu Fig. 1 kann die weichmagnetischen Schicht 3 eine beliebige vorgegebene Struktur bilden.

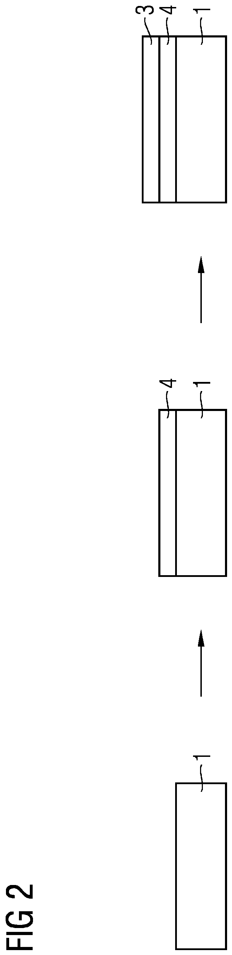

Fig. 2 zeigt den Herstellprozess einer Schirmungsvorrichtung. Ein Substrat 1, z. B. ein Gehäuse aus einem Kunststoff wird mit einer weiteren Schicht 4, z. B. durch Metallisierung mit einer elektrisch leitfähigen Schicht, z. B. aus Kupfer beschichtet. Auch können leitfähige Lacke verwendet werden. Auf die weitere Schicht 4 wird eine weichmagnetische Schicht 3 aufgebracht.

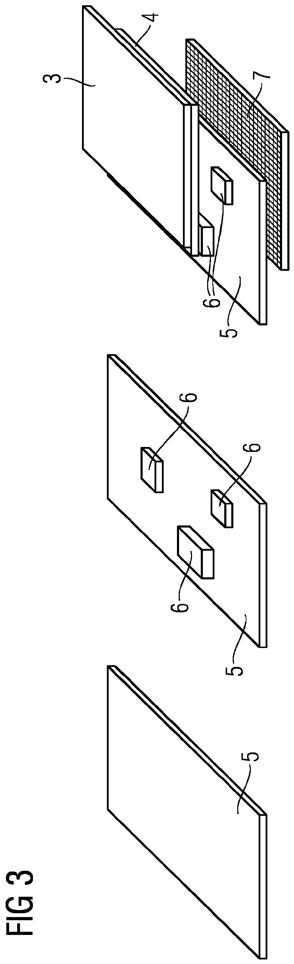

Fig. 3 zeigt eine Schirmungsvorrichtung auf einer Leiterplatte 5, z. B. flexibel-Kapton. Die Leiterplatte 5 ist mit Leiterplattenelemente 6 bestückt. Auf die Seite der Leiterplattenelemente 6 wird eine Mehrlagen-Beschichtung aus einer weichmagnetischen Schicht 3 und einer weiteren Schicht 4 (z. B. Isolation, Kupfer, NiFe) aufgebracht. Zusätzlich kann auf der den Leiterplattenelemente 6 abgewandten Seite eine Rückseitenbeschichtung 7 angebracht werden.

Obwohl die Erfindung im Detail durch die Ausführungsbeispiele näher illustriert und beschrieben wurde, ist die Erfindung durch die offenbarten Beispiele nicht eingeschränkt und andere Variationen können vom Fachmann daraus abgeleitet werden, ohne den Schutzumfang der Erfindung zu verlassen.

## Patentansprüche

1. Verfahren zur Herstellung einer eine elektromagnetische Schirmwirkung aufweisende Schirmungsvorrichtung (2),
**dadurch gekennzeichnet,**
**dass** auf ein Substrat (1) durch Aerosolabscheidung eine Schicht (3) aus einem weichmagnetischen Material aufgebracht wird.

2. Verfahren nach Anspruch 1,
**dadurch gekennzeichnet**,
die Schicht (3) eine beliebige vorgegebene Struktur bildet.

3. Verfahren nach einem der vorherigen Ansprüche,
**dadurch gekennzeichnet,**
**dass** das Substrat (1) ein Gehäuse eines elektronischen Bauteils oder eine Leiterplatte (5) ist.

4. Verfahren nach einem der vorherigen Ansprüche,
**dadurch gekennzeichnet,**
**dass** das Substrat (1) eine schirmende Kupfer- oder Aluminiumschicht ist.

5. Verfahren nach einem der vorherigen Ansprüche,
**dadurch gekennzeichnet,**
**dass** das weichmagnetische Material eine metallische Legierung ist.

6. Verfahren nach Anspruch 5,
**dadurch gekennzeichnet,**
**dass** die metallische Legierung aus einem kristallinen, amorphen oder nanokristallinen Material mit geringem Koerzitivfeld und geringer Magnetostriktion ist.

7. Verfahren nach einem der vorherigen Ansprüche,
**dadurch gekennzeichnet,**
**dass** auf die Schicht (3) zumindest eine weitere Schicht (4) mit aufgebracht ist, wobei die weitere Schicht (4) funktionale Eigenschaften ausweist.

8. Verfahren nach Anspruch 7,
**dadurch gekennzeichnet,**
**dass** die weiteren Schichten (4) elektrisch isolierende und/oder wärmeableitende Eigenschaften aufweisen.

9. Schirmungsvorrichtung (2) mit einer elektromagnetischen Schirmwirkung **aufweisend** eine durch Aerosolabscheidung auf ein Substrat (1) aufgebrachte Schicht (3) aus einem weichmagnetischen Material.
